Europäisches Patentamt

European Patent Office

Office européen des brevets

(19)

(11) Publication number: **0 139 370**

**A1**

(12) **EUROPEAN PATENT APPLICATION**

(21) Application number: **84305418.0**

(22) Date of filing: **09.08.84**

(51) Int. Cl.⁴: **G 01 L 1/18**
**G 01 L 9/00, G 01 L 9/06**

(30) Priority: **12.08.83 GB 8321811**

(43) Date of publication of application:
**02.05.85 Bulletin 85/18**

(84) Designated Contracting States:
**BE DE FR GB IT NL SE**

(71) Applicant: **PRUTEC LIMITED**
**142 Holborn Bars**
**London EC1N 2NH(GB)**

(72) Inventor: **Peeters, Joseph Bonifacius**
**Haachstraat 136a**
**B-3008 Veltem-Beisem(BE)**

(72) Inventor: **Browne, Edward Keith**
**Ave. Beatrice de Cusance 8**
**B-1420 Braine l'Alleud(BE)**

(72) Inventor: **Sierens, Willy Michel**
**Electriciteitstraat 31 Bus 1105**
**B-2800 Mechelen(BE)**

(72) Inventor: **Jensen, Borge Rils**
**Rue Steenvelt 22, Bte 21**
**B-1180 Brussels(BE)**

(74) Representative: **Messulam, Alec Moses**
**A. Messulam & Co. 24 Broadway**
**Leigh on Sea Essex SS9 1BN(GB)**

(54) **Piezoresistive transducer.**

(57) The invention relates to a transducer comprising a resistance bridge 10 having at least one arm 22, 26 formed by a piezoresistive element arranged on a flexible substrate of which at least the surface is not electrically conductive. A voltage is applied across one diagonal of the bridge 10 and an integrator 12 integrates the out of balance voltage of the bridge. The integral is compared by a comparator 16 with a reference signal derived from the voltage applied across the diagonal of the bridge 10 and provides an output of two inverters 30, 32 for reversing the polarity of the applied voltage when the said threshold is crossed. The frequency of reversal of the applied voltage, which is dependent upon the deflection of the substrate, is supplied as an output signal.

FIG.I.

EP 0 139 370 A1

## PIEZORESISTIVE TRANSDUCER

The present invention relates to a piezoresistive transducer for the measurement of strain or pressure.

It is known that a pressure measuring transducer or a strain gauge may be formed by depositing thick film piezoresistive elements on a non-conductive substrate made, for example, of alumina. If the substrate acts as a diaphram, the variations in the resistance may be monitored to measure the deflection of the substrate so as to enable pressure measurement . As an alternative, the substrate may be secured to an element to measure strain.

It it not straight forward to produce calibrated repeatable readings from measurement of the resistance of such a piezoresistive element. One reason for this is that the resistance varies due to temperature effects. Furthermore, if long leads connect the transducer to the circuitry for analysing the changes in resistance, the resistance of these leads must also be taken in consideration.

In order to reduce such disadvantages as mentioned above, it is already known to form the resistors on the substrate in the form of a Wheatstone bridge so that the resistance may be measured by measurement of an out of balance voltage. However, the calibration of such a transducer is difficult to achieve in practice because the variation of the voltage with deflection does not follow a simple mathematical relationship. Another source of difficulty is that the out of balance voltage of the bridge is also dependent upon the applied voltage.

The present invention seeks to provide a transducer in which at least some of the foregoing disadvantages are mitigated.

In accordance with the present invention, there is provided a transducer comprising a resistance bridge having at least one arm formed by a piezoresistive element arranged on a flexible substrate of which at least the surface is not electrically conductive, means for applying a voltage across one diagonal of the bridge, means for integrating the out of balance voltage of the bridge, means for comparing the integrated out of balance voltage with a reference signal derived from the voltage applied across said one diagonal and means for reversing the polarity of the applied voltage when the said threshold is crossed whereby the frequency of reversal of the applied voltage is dependent upon the deflection of the substrate.

Preferably, the circuit is constructed in the form of a thick film hybrid circuit supported on the same substrate as the piezoresistive elements. In this case, the output signal of the transducer is in the form of a variable frequency which is unaffected by the length of the transmission lines or other noise picked up by such lines.

A disadvantage of commonly used pressure transducers and strain gauges is that they are formed on a ceramic material which is brittle and cannot be deformed excessively. This places limitations on the pressure range that can be measured by any given transducer.

In a preferred embodiment of the invention, the substrate is formed of a metal having an enamel or glass ceramic coating.

The invention will now be described further, by way of example, with reference to the accompanying drawings, in which:

Figure 1 is a circuit diagram of a transducer in accordance with the invention,

Figure 2 is a diagram of the voltage waveforms at different points in the circuit of Figure 1, and

Figure 3 shows schematically a section to illustrate the mecahnical construction of a transducer of the invention.

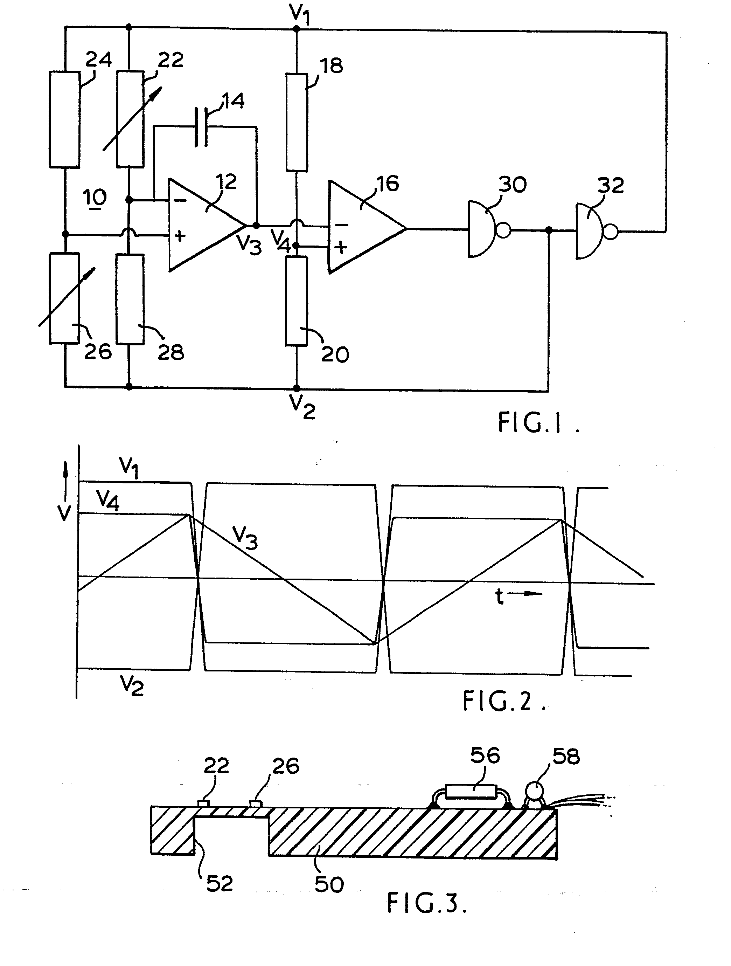

In Figure 1, a Wheatstone bridge circuit 10 is made up of four nominally equal piezoresistive thick film resistors 22, 24, 26 and 28 of which two resistors 22 and 26 are on a deflectable part of the substrate with the result that their resistance varies with the applied pressure or strain to be measured whereas the resistors 24 and 28 are arranged such that their resistance does not depend upon deflection of the substrate.

The out of balance voltage of the resistance bridge 10 is applied to the inputs of an operational amplifier 12 of which the output is fed back to the inverting input by way of a capacitor 14 to form an integrator. The output of the operational amplifier 12 is further fed to one input of a second operational amplifier 16 of which the second input is connected to the junction between two resistors 18, 20 which constitute a potential divider connected across the voltage applied to the resistance bridge 10. The second operational amplifier 16 serves as a comparator or Schmitt trigger and produces an output signal when the integrated out of balance current of the bridge exceeds the threhold value set by the voltage divider 16, 18.

The output signal of the operational amplifier 16 is applied to the input of the first of two sries connected inverters 30, 32 which, in response, reverse the polarity of the voltage to the bridge 10.

In a practical embodiment, the two operational amplifiers 12, 16 may be formed as a single integrated cicuit (for example, a TL 082 CP) and the two inverters may likewise be formed on a single integrated circuit (for example, a HEF 4001B). The amplifiers and inverters are connected to a D.C. power supply but the connections are not shown in the drawing, in the interest of clarity.

Possible the component values for the described circuit are as follows:

|              |          |
| ------------ | -------- |
| Resistor 22  | 10 Kohm  |
| Resistor 24  | 10 Kohm  |
| Resistor 26  | 10 Kohm  |
| Resistor 28  | 10 Kohm  |
| Resistor 18  | 10 Kohm  |
| Resistor 20  | 33 Kohm  |
| Capacitor 14 | 47 nF    |

Figure 2 shows voltage waveforms at different points in circuit of Figure 1. The voltages is V1 and V2 are the voltages applied to the resistance bridge 10. The voltage V3 represents the output of the integrator 12 and the voltage V4 is the reference threshold applied to the comparator 16 by the voltage devider 18, 20. Initially, assuming that the bridge is not in balance, an out-of-balance current is integrated by the integrator and slowly the value of V3 rises until the threshold V4 is crossed. At this point, V1 and V2 are rapidly reversed and consequently the polarity of the out of balance voltage is also reversed as well as the polarity of the threshold value. The integrator output therefore now decays and the polarity is once again reversed when the lower threshold is crossed. Consequently, reversal takes place at a rate determined by the rate at which the integrator output voltage rises. The frequency of reversal is clearly dependent upon the out of balance voltage and consequently the higher the imbalance of the resistances the higher frequency of oscillation.

The oscillation frequency may be fed over a separate signal line to a remote instrument or alternatively, if the power consumption of the circuit is arranged to vary with polarity, then the current drawn through the supply lines 10 and 12 will also fluctuate thereby enabling the frequency to be measured using only two lines between the transducer and the display instrument.

It can be shown that to a good approximation, the frequency f of reversal of the power supply to the bridge is given by the equation:

$$f = P.\{(R18 + R20) / 2.R22.C.(R20 - R18)\}$$

where R18 is the resistance of resistor 18,
R20 is the resistance of resistor 20,
R22 is the resistance of resistor 22, and
C is the capacitance of the capacitor 14.

The frequency, in other words, is substantially linearly related to the applied pressure or strain which simplifies calibration and provides constant sensitivity over the measurement range.

In Figure 3, a transducer comprises a substrate 50 which is enamelled or coated with a glass ceramic material so as to be electrically insulating its surface. The piezoresistive elements 22, 26 are formed over a diaphragm produced by a recess 52 in the opposite surface of the substrate 50. The circuit elements of the circuit in Figure 1 are mounted on the same substrate and are represented by the components 56, 58. The interconnections between the components are formed by conductors printed on the surface of the substrate 50.

The advantage of using a glass ceramic coated or enamelled substrate is that it is less brittle than a ceramic substrate and thereby allows a greater degree of flexibility and measurement range. Furthermore, such a substrate may be machined to form the recess 52 to provide local thinning thereby permitting the construction of transducers with greater sensitivity.

If it should be desired to produce an absolute pressure transducer, then the recess 52 may be sealed by means of a cover and evacuated. In this way the diaphragm constituted by the base of the recess 52 will be acted upon on the one side by the pressure to be measured and on other by a pressure of substantially zero.

In addition to the advantatages mentioned above, the transducer of the preferred embodiment is substantially insensitive to input offset voltage and current of the operational amplifier 12. The effect of these is to disturb the symmetry of the triangular waveform V3, but not the frequency. The circuit is therefore similarly insensitive to offset drifts caused by temperature variations or ageing of the active components.

A still further advantage is that because the threshold voltage is derived from the voltage across the resistance bridge, the frequency is independent of the supply voltage over a wide range.

For initial balance of the resistance bridge, the thick film resistors may be trimmed by laser and the sensitivity may be set by trimming of the resistors 18 and 20.

0139370

## CLAIMS

1. A transducer comprising a resistance bridge (10) having at least one arm (22 to 28) formed by a piezoresistive element arranged on a flexible substrate of which at least the surface is not electrically conductive, means for applying a voltage (V1,V2) across one diagonal of the bridge (10), and means (12) for sensing the out of balance voltage, charaterised by means (12,14) for integrating the out of balance voltage of the bridge, means (16) for comparing the integrated out of balance voltage with a reference voltage (V4) derived from the voltage applied across said one diagonal and means (30,32) for reversing the polarity of the applied voltage when the said threshold is crossed, whereby the frequency of reversal of the applied voltage is dependent upon the deflection of the substrate.

2. A transducer as claimed in claim 1, wherein all the circuit elements are constructed in the form of a thick film hybrid circuit supported on the same substrate (50) as the piezoresistive elements (22 to 28).

3. A transducer as claimed in claim 2, wherein the substrate (50) is formed of a metal having an enamel or glass ceramic coating.

FIG.1.

FIG.2.

FIG.3.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-2 039 057 (J. WHITE & SON)  * Page 1, lines 75-122; figure 1 * | 1 | G 01 L 1/18  G 01 L 9/00  G 01 L 9/06 |
| X | JOURNAL OF PHYSICS E. SCIENTIFIC INSTRUMENTS, vol.16, no. 4, April 1983, Dorking, GB; T. SIDOR "Simple and accurate strain gange signal-to-frequency converter", pages 253-255  * Page 253; figure 1 * | 1 | |
| P,A | DE-A-3 207 833 (SIEMENS AG.)  * Abstract; figure 1 * | 2 | |
| A | DE-B-2 349 463 (MOTOROLA)  * Claims 1, 3; figures 2, 4 * | 2 | TECHNICAL FIELDS SEARCHED (Int. Cl.4)  G 01 L 1/18  G 01 L 1/22  G 01 L 9/00 |

The present search report has been drawn up for all claims

| Place of search BERLIN | Date of completion of the search 16-11-1984 | Examiner KOEHN G |
|---|---|---|